# EUROPEAN PATENT APPLICATION

(11) **EP 2 009 796 A1**
(43) Date of publication of application: **31.12.2008**
(21) Application number: 07301172.8
(22) Date of filing: 28.06.2007
(51) Int. Cl.: H03L 7/093, H03L 7/107

(54) **Method for filtering a signal in a phase-locked loop, phase locked loop, base station and communication network therefor**

(71) Applicant: Alcatel Lucent, 75008 Paris (FR)
(72) Inventor: Schlesinger, Heinz, 74395, Mundelsheim (DE)
(74) Representative: Brose, Gerhard

(57) **Abstract**

The invention concerns a method for filtering a signal in a phase-locked loop by means of a phase-locked loop filter (DPF), whereby a microcontroller (µC) adapted to perform digital filter algorithms and comprised in said phase-locked loop filter (DPF) filters said signal dependent on a desired frequency that shall be generated by the phase-locked loop, a phase locked loop., a base station and a communication network therefor.

## Description

The invention relates to a method for filtering a signal in a phase-locked loop according to the preamble of claim 1, a phase-locked loop according to the preamble of claim 6, a base station according to the preamble of claim 7, and a communication network according to the preamble of claim 8.

Software-defined radio (SDR) systems basically are radio communication systems which can be tuned by means of software-controlled programmable hardware over a broad frequency band thus covering a variety of radio access technologies with different bearer frequencies. Furthermore, a variety of modulation schemes can be chosen by means of software-controlled procedures depending on the appropriate radio access technology.

Examples for said radio access technologies are GSM (GSM = Global System for Mobile Communications), UMTS (UMTS = Universal Mobile Telecommunications System), CDMA 2000 (CDMA = Code Division Multiple Access) or WIMAX (WIMAX = Worldwide Interoperability for Microwave Access).

Radio communication systems such as software-defined radio (SDR) systems comprise base stations with a so-called phase-locked loop (PLL) in the transceiver which has mainly the task to synchronize the radio frequency to a reference frequency.

A phase-locked loop uses a phase-locked loop filter as a lowpass filter for filtering control signals of a phase frequency detector which are used for generation of desired radio frequency signals by a so-called voltage-controlled oscillator (VCO).

The PLL filter according to the prior art is designed as a circuit of analogue passive components. The analogue PLL filter component design is a compromise to achieve best phase noise behaviour for a certain operating point depending on desired phase-locked loop bandwidth and the phase frequency detector frequency, i.e. the reference frequency.

Such a phase-locked loop with an analogue PLL filter is e.g. described in the US patent US 4,803,705..

Without additional digital frequency tuning of the phase frequency detector by means of a numerically-controlled oscillator (NCO), the phase frequency detector frequency is equal to the radio frequency step sise between the radio channels of e.g. 200 kHZ in GSM and UMTS systems,

However in SDR applications additional digital fine tuning to adjust the radio channel step size by means of numerically-controlled oscillators is one of the key ideas. Hence the phase frequency detector frequency is hot constant and hence the analogue PLL filter can be only a compromise but not the best result in view of phase noise behaviour that reflect in error vector magnitude (EVM) and peak code domain error (PCDE) behaviour. The better the phase-locked loop phase noise behaviour is, the better EVM and PCDE behaviour and hence the overall system performance will be.

The object of the invention is thus to propose a method for filtering a signal in a phase-locked loop with a non-constant phase frequency detector frequency by means of a phase-locked loop filter which offers an improved EVM and PCDE behaviour.

This object is achieved by a method according to the teaching of claim 1, a phase-locked loop according to the teaching of claim 6, a base station according to the teaching of claim 7, and a communication network according to the teaching of claim 8.

The main idea of the invention is to extend or replace the fix analogue PLL filter with an adjustable digital filter.

Further developments of the invention can be gathered from the dependent claims and the following description.

In the following the invention will be explained further making reference to the attached drawings.
Fig. 1 schematically shows a phase-locked loop according to the prior art.
Fig. 2 schematically shows an analogue phase-locked loop filter according to the prior art.
Fig. 3 schematically shows a phase-locked loop according to the invention using a digital phase-locked loop filter.

According to the prior art, a phase-locked loop comprises an analogue phase-locked loop filter.

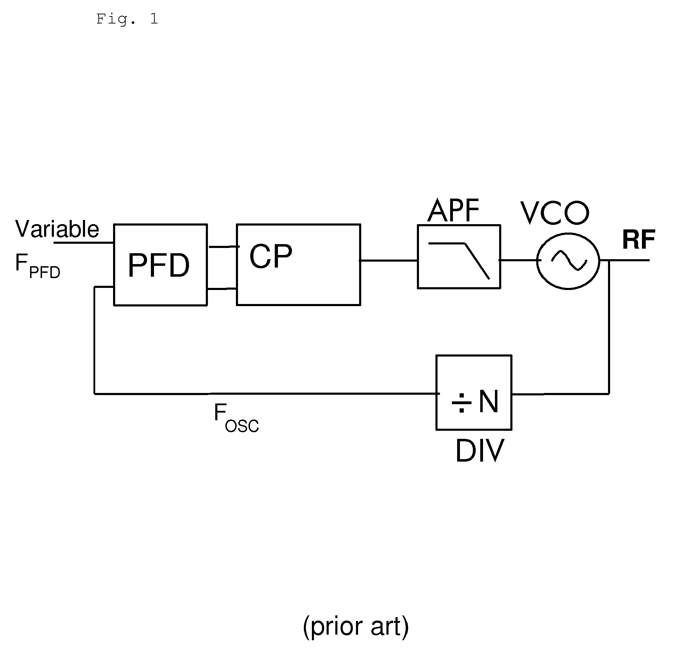

Fig. 1 shows an example for such a phase-locked loop. The phase-locked loop comprises a phase frequency detector PFD which has an input for a reference, frequency F_{PFD}, an input connected to a divider DIV for receiving an oscillator frequency F_{OSC}, and two outputs connected to a charge pump CP.

The output of the charge pump GP is connected to the input of an analogue PLL filter APF.

The output of the analogue PLL filter APF in turn is connected to a voltage controlled oscillator VCO.

The output of the voltage controlled oscillator VCO is connected both to the input of the divider Div and to at least one antenna via a front end unit performing amplification, which is not shown in fig. 1 for the sake of simplicity.

The phase frequency detector PFD receives via the first input the reference frequency F_{FFD}, and via the second input from the divider DIV a reduced oscillator frequency F_{OSC}, which shall be synchronized to the reference frequency F_{PFD}.

The phase frequency detector PFD determines the difference between the reference frequency F_{PFD} and the reduced oscillator frequency F_{OSC}. Depending on whether this difference is positive or negative, a current pulse is sent over the first output or over the second output to the charge pump CP.

The load of capacitors in the charge pump CP is increased or reduced depending on whether the current pulse is received over the first or the second input. Depending on the charge of the charge pump, a higher or lower control voltage is generated at the output and sent to the analogue PLL, filter APF.

In the analogue PLL filter APF, higher frequencies are filtered out of the of the control voltage in order to obtain a control voltage that is simply dependent on the difference between the reference frequency F_{PFD} and the reduced oscillator frequency F_{OSC}.

Said filtered control voltage is used as input voltage for the voltage controlled oscillator VCO. There is a linear dependency between the input voltage and the frequency RF of the generated output voltage of the voltage controlled oscillator VCO. The frequency RF is unchanged if the input voltage is equal to zero.

The output voltage with the frequency RF of the voltage controlled oscillator VCO is in turn used as control voltage for the radio transmission of one or more antennas by means of a front end unit.

Furthermore, in the divider DIV, the frequency RF of the output voltage is divided by N, and the thus reduced oscillator frequency F_{OSC} is used by the phase frequency detector PFD to determine the difference between the reference frequency F_{PFD} and the reduced oscillator frequency as described above.

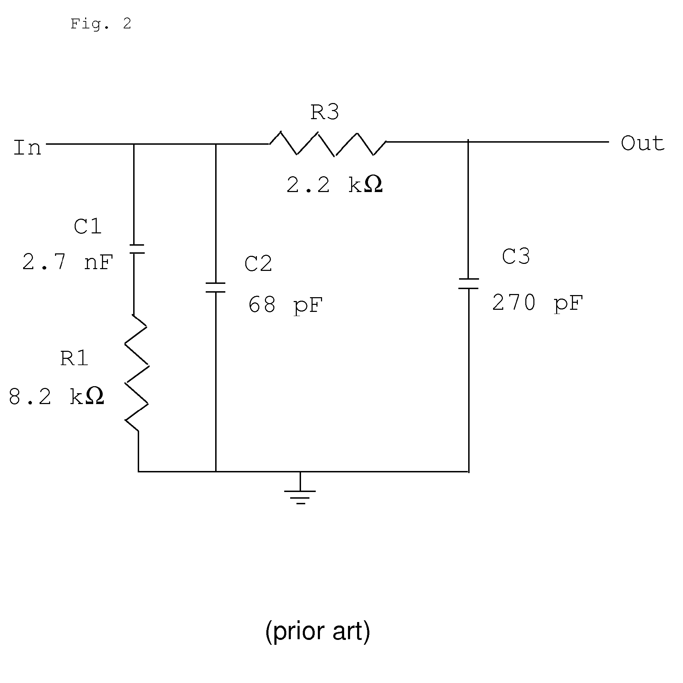

Fig. 2 shows an example of an analogue PLL filter APF according to the prior art.

The input In of the analogue PLL filter APF is connected to output Out via a resistor R3 with a fixed resistance of 2.2 kΩ.

Furthermore, the input In is connected via a capacitor C1 with a fixed capacity of 2.7 nF, a resistor R1 with a fixed resistance of 8.2 kΩ, and a capacitor C3 with a fixed capacity of 270 pF with the output Out.

The input In is also connected via a capacitor C2 with a fixed capacity of 68 pF and the capacitor C3 with a fixed capacity of 270 pF with the output Out.

The analogue PLL filter APF designed as a circuit of fix analogue passive, components is a compromise to achieve best phase noise behaviour for a certain operating point depending on the desired bandwidth of the phase-locked loop and the reference frequency F_{PFD}.

The resolution of the frequency RF of the output voltage is determined by the reference frequency F_{PFD} applied to the phase frequency detector PFD. If a spacing of the radio channels of e.g. 200 kHZ is required, as e.g. in the case of GSM and UMTS systems, then the reference frequency F_{PFD} must be 200 kHz. That means that according to the state of the art in GSM and UMTS systems, the the reference frequency F_{PFD} applied to the phase frequency detector PFD is a fix value of 200 kHz.

However, as already mentioned above, in SDR applications additional digital fine tuning to adjust the radio channel step size by means of numerically-controlled oscillators is one of the key ideas. Hence the reference frequency F_{PFD} of the phase frequency detector is not constant and hence the analogue PLL filter is a suboptimal solution, as it is optimized for a certain fix operating point dependent on the desired bandwidth of the phase-locked loop and the reference frequency F_{PFD}

According to the Invention, in order to have a phase-locked loop with a phase noise behaviour optimized for an applied flexible reference frequency F_{PFD}, it is proposed to extend or replace the fix analogue PLL filter with an adjustable digital PLL filter.

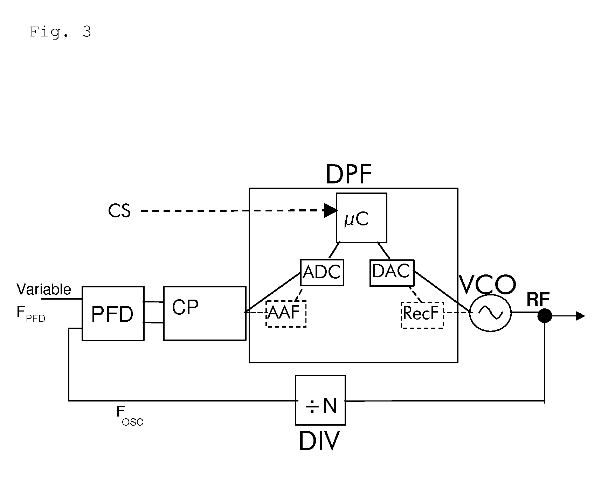

Fig. 3 shows an example for a phase-locked loop with a digital PLL filter DPF.

The design and functioning of the phase-locked loop is similar to the state of the art as described above with the difference that the analogue PLL filter APF of fig. 1 is replaced by a digital PLL filter DPF in fig. 3.

According to the invention, the output of the charge pump CP is connected to an analogue to digital converter ADC which is in turn connected to the input of a microcontroller µC.

The output of the microcontroller µC is connected to a digital to analogue converter BAC which is in turn connected to the voltage controlled oscillator VCO.

The analogue signals of the control voltage generated at the output of the charge pump CP is in the analogue to digital converter ADC converted into digital signals.

Said digital signals are sent to the microcontroller µC, in which adaptable and reconfigurable digital filter algorithms are running to adjust and optimise the overall PLL filter characteristics in dependence of the reference frequency F_{PFD} and the loop bandwidth to achieve best PLL phase noise characteristics.

The filtered digital signals are sent from the the microcontroller µC to the digital to analogue converter DAC, where said filtered digital signals are converted into an analogue voltage.

Said analogue voltage is used as input voltage for the voltage controlled oscillator VCO.

In an embodiment of the invention, the digital PLL filter DPF comprising the analogue to digital converter ADC, the microcontroller µC and the digital to analogue converter DAC is used in addition to an analogue PLL filter APF in the signal path between the charge pump CP and the voltage controlled oscillator VCO.

In an embodiment of the invention, the analogue signals of the control voltage generated at the output of the charge pump CP is fed to an anti aliasing filter AAF. The anti aliasing filter AAF is used to restrict the bandwidth of the analogue signals of the control voltage to approximately satisfy the Shannon-Nyquist-Kotelnikov theorem, in order to allow an unambiguous interpretation of the signals after digitisation.

The analogue signals filtered by the anti aliasing filter AAF are fed to the input of the analogue to digital converter ADC.

In fig. 3, the anti aliasing filter AAF and its connection to the charge pump CP and the analogue to digital converter ADC are depicted as a dotted box and dotted lines respectively.

In another embodiment of the invention, the filtered digital signals that are converted into an analogue voltage in the digital to analogue converter DAC are fed to a reconstruction filter RecF. The reconstruction filter RecF is used to construct smooth analogue signals out of the analogue voltage at the output of the digital to analogue converter DAC.

The smoothed analogue signals are used as input voltage for the voltage controlled oscillator VCO.

In fig. 3, the reconstruction filter RecF and its connection to the digital to analogue converter DAC and the voltage controlled oscillator VCO are depicted as a dotted box and dotted lines respectively.

In a preferred embodiment of the invention, the microcontroller µC receives a control signal CS indicating or allowing for an evaluation of filter parameters, and the digital filter algorithms are adjusted using said filter parameters automatically by means of said control signal CS.

In fig. 3, the sending of said control signal CS to the microcontroller µC is depicted as a dotted arrow.

Preferably, said control signal CS is sent by a control device that also sends another control signal indicating or allowing for an evaluation of the reference frequency F_{PFD} to the phase frequency detector PFD comprised in the phase-locked loop.

## Claims

1. A method for filtering a signal in a phase-locked loop by means of a phase-locked loop filter (DPF) **characterized in, that** a microcontroller (µC) adapted to perform digital filter algorithms and comprised in said phase-locked loop filter (DPF) filters said signal dependent on a desired frequency that shall be generated by the phase-locked loop.

2. A method according to claim 1, **characterized in, that** said microcontroller (µC) receives a control signal (CS) indicating or allowing for an evaluation of filter parameters and that said digital filter algorithms are adjusted using said filter parameters automatically by means of said control signal (CS).

3. A method according to claim 2, **characterized in, that** said control signal (CS) is sent by a control device that also sends another control signal indicating or allowing for an evaluation of the desired frequency to a phase frequency detector (PFD) comprised in the phase-locked loop.

4. A method according to claim 1, **characterized in, that** said signal is filtered by means of an anti-aliasing filter (AAF) before the signal is sent to the microcontroller (µC).

5. A method according to claim 1, **characterized in, that** the microcontroller (µC) sends said signal to a reconstruction filter (RecF) via a digital to analogue converter (DAC).

6. A phase-locked loop comprising at least one phase-locked loop filter (DPF) for filtering a signal **characterized in, that** said at least one phase-locked loop filter (DPF) comprises at least one microcontroller (µC) adapted to perform digital filter algorithms for filtering said signal dependent on a desired frequency that shall be generated by the phase-locked loop.

7. A base station for radio transmission comprising at least one phase-locked loop with at least one phase-locked loop filter (DPF) **characterised in, that** said at least one phase-locked loop filter (DPF) comprises at least one microcontroller (µC) adapted to perform digital filter algorithms for filtering a signal dependent on a desired frequency that shall be generated by said at least one phase-locked loop.

8. A communication network comprising at least one base station for radio transmission comprising at least one phase-locked loop with at least one phase-locked loop filter (DPF) **characterized in, that** said at least one phase-locked loop filter (DPF) comprises at least one microcontroller (µC) adapted to perform digital filter algorithms for filtering a signal dependent on a desired frequency that shall be generated by said at least one phase-locked loop.
